# EUROPEAN PATENT APPLICATION

(11) **EP 1 642 949 A1**
(43) Date of publication of application: **05.04.2006**
(21) Application number: 05021269.5
(22) Date of filing: 29.09.2005
(51) Int. Cl.: C09G 1/02, C09K 3/14, H01L 21/306

(54) **Polishing composition and method of polishing with the same**

(30) Priority: 29.09.2004 JP 2004284257
(71) Applicant: FUJI PHOTO FILM CO., LTD., Manami-Ashigara-shi Kanagawa (JP)
(72) Inventor: Takenouchi, Kenji, Yoshida-cho Haibara-gun Shizuoka (JP)
(74) Representative: HOFFMANN EITLE

(57) **Abstract**

A polishing composition comprises: at least one compound selected from tetrazole compounds and derivatives thereof and anthranilic acid compounds and derivatives thereof; abrasive particles comprising associative abrasive particles; and an oxidizing agent.

## Description

### Background of the Invention

### 1. Field of the Invention

The present invention relates to semiconductor device production. More particularly, the invention relates to a polishing composition for use in a wiring step in semiconductor device production and to a method of polishing with the composition.

### 2. Description of the Related Art

In the development of semiconductor devices represented by semiconductor integrated circuits (hereinafter referred to as LSIs), there recently is a desire to attain a higher density/higher degree of integration based on the scale down and multilayer arrangement of wirings so as to meet the trend toward higher degrees of integration and higher speeds. Chemical mechanical polishing (hereinafter referred to as CMP) has been used as a technique for these. This technique is used for the polishing of insulating thin films (e.g., SiO₂) and thin metal films for use as wirings, and is a method for substrate planarization or the removal of excess thin metal films in wiring formation. A method of this technique is disclosed in, e.g., U.S. Patent 4,944,836.

Polishing solutions for the CMP of metals generally contain abrasive grains (e.g., alumina) and an oxidizing agent (e.g., hydrogen peroxide). The basic mechanism is thought to comprise the oxidation of the metal surface with the oxidizing agent and the removal of the resultant oxide film with the abrasive grains. This mechanism is described in, e.g., *Journal* of *Electrochemical* society, 1991, Vol.138, No.11, pp.3460-3464.

However, there are cases where CMP with such a polishing composition containing solid abrasive grains results in troubles such as polishing mars (scratches), a phenomenon in which the whole surface to be polished is excessively polished (thinning), a phenomenon in which the metal surface to be polished becomes recessed like a dish (dishing), and a phenomenon in which the insulator between metal wirings is excessively polished and the surface of the wiring metal becomes recessed like a dish (erosion).

In addition, the cleaning step which is usually conducted after the polishing in order to remove the polishing liquid remaining on the semiconductor surface is complicated because of the use of the polishing liquid containing solid abrasive grains. Furthermore, there are problems concerning cost, for example, because the treatment of the liquid resulting from the cleaning (waste liquid) necessitates separation of the solid abrasive grains by sedimentation.

A measure for eliminating these problems, for example, is disclosed in *Journal of Electrochemical Society,* 2000, Vol.147, No.10, pp.3907-3913, which is a method of polishing a metal surface by a combination of use of a polishing liquid containing no abrasive grains and dry etching. In JP-A-2001-127019 is disclosed a polishing composition comprising hydrogen peroxide, malicacid, benzotriazole, poly(acrylic acid) ammonium salt, and water. According to these techniques, the metal film in protrudent parts of the semiconductor substrate is selectively removed by CMP and the metal film in recessed parts are left to thereby obtain a desired conductor pattern. Since the CMP proceeds as a result of friction with a polishing pad which is mechanically far softer than those heretofore in use which contain solid abrasive grains, scratching is diminished.

On the other hand, metals for wiring include tungsten and aluminum, which have generally been used as interconnection structures. Polishing liquids and methods for the polishing of tungsten and aluminum are described in, e.g., JP-A-11-349926 and JP-A-9-22887. However, LSIs employing copper, which has lower wiring resistance than these metals, have come to be developed so as to attain higher performances. Known as a method of copper wiring is, for example, the damascene method described in JP-A-2-278822. Furthermore, the dual damascene method has come to be extensively used in which contact holes and grooves for wiring are simultaneously formed in an interlayer dielectric and are filled with a metal. High-purity copper targets having a purity of 99.999% or higher have been supplied as the target materials for the copper wiring. In recent years, however, it has become necessary to improve the conductivity, electronic properties, and other properties of copper wirings with the trend toward scale down in wirings for an even higher density. For attaining this, use of a copper alloy obtained by adding a third ingredient to high-purity copper has come to be investigated. Simultaneously therewith, there is a desire for a high-rate metal-polishing technique which can exhibit high productivity without fouling these high-resolution high-purity materials. The copper wirings are apt to develop mars called scratches as compared with aluminum wirings heretofore in use and, on the other hand, have a problem that because of the ductility thereof, a high polishing rate is not attained.

In addition, the diameters of wafers for use in LSI production are increasing recently in order to improve productivity. At present, wafers having a diameter of 200 mm or larger are generally used. Production with wafers of 300 mm or a large size has been initiated. Such increase in wafer size resulted in a larger difference in polishing rate in each wafer between a central part and a peripheral part. There is hence a growing desire for an improvement in in-plane evenness.

Japanese Patent 3,509,188, JP-A-8-8218 and JP-A-2001-226666 disclose abrasive particles having a coating layer from the standpoints of an improvement in polishing rate, scratching inhibition, etc.

### Summary of the Invention

The invention has been achieved under the circumstances described above in which the rate of polishing of wirings formed from such copper metal and copper alloys is desired to be increased for more rapid CMP in order to heighten the productivity of LSIs.

Accordingly, an object of the invention is to provide a polishing composition which has a high CMP rate and enables chemical mechanical polishing reduced in dishing and scratching.

The present inventors made intensive investigations on the problems of polishing compositions described above. As a result, it has been found that the problems can be eliminated by using the polishing composition described below. The object has been thus achieved. Namely, the invention provides the following.
(1) A polishing composition comprising: at least one compound selected from tetrazole compounds and derivatives thereof and anthranilic acid compounds and derivatives thereof; abrasive particles comprising associative abrasive particles; and an oxidizing agent.
(2) The polishing composition as described under (1) above wherein the proportion of the associative abrasive particles is 10% by volume or higher based on all the abrasive particles.
(3) The polishing composition as described under (1) or (2) above wherein the associative abrasive particles have an average major-axis length in the range of 10-300 nm and a degree of association higher than 1 and not higher than 10.
(4) A method of chemical mechanical polishing which comprises bringing the polishing composition as described under any one of (1) to (3) above into contact with a surface to be polished and polishing the surface by moving it relatively to a polishing surface.

The present inventors found that for eliminating the problems described above, it is effective to employ a polishing composition containing associative abrasive particles and one or more compounds selected from tetrazole compounds and derivatives thereof and anthranilic acid compounds and derivatives thereof.

Compared to abrasive particles having a relatively low degree of association or to primary particles, abrasive particles having a relatively high degree of association not only have a high polishing rate but also have a higher polishing rate especially in polishing on the higher-pressure side. Due to this feature, these abrasive particles relatively rapidly remove those parts of the work surface which receive a higher pressing pressure, such as protrudent parts. These abrasive particles thus rapidly eliminate the steps attributable to recesses and protrusions of the metal wiring layer and efficiently remove an excess metal wiring layer also. Consequently, a high throughput also is attained. However, since associative particles have relatively high abrading power, they have had a problem that the work surface is damaged by scratches.

In the invention, a polishing liquid containing the associative abrasive particles having high planarization ability and dishing-inhibiting ability and further containing at least one of tetrazole compounds and derivative thereof and anthranilic acid compounds and derivatives thereof is used for the CMP. It has been found that due to the use of this polishing liquid, a work surface having resistance to scratching can be formed while maintaining high abradingpower and satisfactory dishing-inhibiting ability.

In the polishing liquid of the invention, the tetrazole compound or its derivative or the anthranilic acid compound or its derivative is thought to be adsorbed onto or bonded to metal wiring parts or a barrier layer surface to form a protective layer and thereby effectively protect against scratching by the abrasive particles, abrading layer, etc.

A polishing liquid having excellent non-scratching properties while retaining the high abrading power and high planarization ability attributable to associative particles has been thus developed.

The higher the abrasion of recessed parts, the more the dishing is enhanced. It is therefore desirable that the abrasion of recessed parts be low.

Namely, the following is thought. When excess metal wirings on a substrate are to be removed by CMP, lowly associative abrasive particles and primary particles are apt to abrade the wiring parts becoming lower than the barrier layer through excessive polishing, due to their relatively high degree of freedom. On the other hand, highly associative abrasive particles are less apt to abrade due to their shape and have satisfactory performance.

### Detailed Description of the Invention

### Embodiments of the Invention will be explained below.

The polishing composition of the invention, which is used as a polishing liquid for chemical mechanical polishing in semiconductor device production, contains: at least one compound selected from tetrazole compounds and derivatives thereof and anthranilic acid compounds and derivatives thereof; associative abrasive particles; and an oxidizing agent.

The polishing composition of the invention usually is an aqueous solution.

It is preferred that the composition should contain at least one member selected from organic acids and amino acids.

The polishing composition of the invention may further contain other ingredients. Preferred ingredients include surfactants, water-soluble polymers, and additives.

Each of such ingredients contained in the polishing composition may consist of one compound or comprise a combination of two or more compounds.

The term "polishing composition" as used in the invention means a conception which includes not only a polishing liquid for use in polishing (i.e., a polishing liquid which has been optionally diluted) but also a polishing liquid as a concentrate. The term "concentrate" or "concentrated polishing liquid" means a polishing liquid prepared so as to have a higher solute concentration than the polishing liquid which is being used for polishing. The concentrate or concentrated polishing liquid is diluted with water, an aqueous solution, or the like at time of use in polishing. The dilution ratio is generally from 1 to 20 times by volume. The terms "concentrated" and "concentrate" in this specification are used according to common use so as to mean "thicker" and "thicker liquid" as compared with the state in use. Namely, these terms here are used so as to have meanings different from those of the general usage which include a physical concentrating operation, e.g., evaporation.

The constituent ingredients will be explained below. (Associative Abrasive Particles)

The associative abrasive particles contained in the polishing composition of the invention are particles each of which is made up of particles which originally had separate particle boundaries and have come to move as a single particle in space due to chemical bonds among these. Examples thereof include cocoon-form colloidal silica particles (described in, e.g., JP-A-11-60232).

The degree of association can be calculated as (particle diameter)/(primary-particle diameter).

Examples of methods for preparing associative abrasive particles include the following methods.

An alkoxysilane is hydrolyzed to grow colloidal silica. In this operation, the rates of dropping of starting materials described herein are regulated to change the degree of association. Besides this, use can be made of a method in which the hydrolysis is conducted initially at a pH of 2-4 and finally at a pH of 9-10 to thereby yield associative particles. The longer the period in which the pH is in an acid region, the higher the tendency that highly associative particles are formed.

Although other kinds of abrasive particles such as those described below may be used in combination with the associative abrasive particles, the proportion of the associative abrasive particles in all particles contained in the polishing liquid is preferably 10% by volume or higher, more preferably 40% by volume or higher, from the standpoints of dishing-inhibiting ability and improvement in polishing rate.

From the standpoint of preventing scratch formation in the work surface, the major-axis length of the associative abrasive particles is preferably 300 nm or shorter, more preferably 10-300 nm. It is also preferred that the major-axis length of the associative abrasive particles should be up to 5 times the minor-axis length thereof.

Furthermore, from the standpoint of narrowing the width of distribution of the degree of association to thereby prevent scratching, the degree of association is preferably higher than 1 and not higher than 10, and is more preferably in the range of 1.2-10, even more preferably in the range of 1.2-4.

Examples of other abrasive particles which may be used in combination with the associative abrasive particles according to the invention include abrasive grains in general use. Specific examples thereof include silicas (precipitated silica, fumedsilica, colloidal silica, and synthetic silica), ceria, alumina, titania, zirconia, germania, manganese oxide, silicon carbide, polystyrene, polyacrylics, and polyterephthalates. Such abrasive grains have an average particle diameter of preferably 5-1,000 nm, especially preferably 10-200 nm.

The total amount of all abrasive particles comprising the associative abrasive particles according to the invention and other abrasive particles is preferably 0.01-20% by mass, more preferably 0.05-5% by mass, based on the whole polishing composition in use. From the standpoint of obtaining a sufficient effect concerning polishing rate, the total amount of all abrasive particles is preferably 0.01% by mass or larger. In view of a limitation of improvement in CMP rate, the total amount thereof is preferably 20% by mass or smaller. (Tetrazole Compounds and Derivatives thereof and Anthranilic Acid Compounds and Derivatives thereof) The polishing composition further contains at least one compound selected from tetrazole compounds and derivatives thereof and anthranilic compounds and derivatives thereof.

The tetrazole compounds and derivatives thereof preferably are compounds represented by formula (I), while the anthranilic acid compounds and derivatives thereof preferably are compounds represented by formula (II).

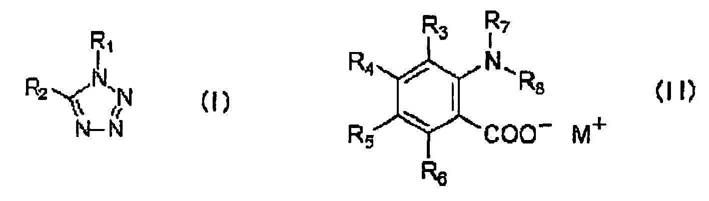

In formula (I), R₁ and R₂ each independently represent a hydrogen atom or a substituent, provided that R₁ and R₂ may be bonded to each other to form a ring. In the case where R₁ and R₂ each simultaneously are a hydrogen atom, the compound represented by general formula (I) may be a tautomer thereof.

In formula (II), R₃ to R₈ each independently represent hydrogen atom or a substituent, provided that any adjacent two of R₃ to R₆ may be bonded to each other to, form a ring. M⁺ represents a cation.

With respect to expressions of groups (atomic groups) in this specification, the expressions including neither "substituted" nor "unsubstituted" mean both groups having no substituent and groups having one or more substituents. For example, "alkyl group" means both an alkyl group having no substituent (unsubstituted alkyl group) and an alkyl group having one or more substituents (substituted alkyl group).

The substituents represented by R₁ and R₂ in formula (I) are not particularly limited and examples thereof include the following.

Examples of the substituents represented by R₁ and R₂ include halogen atoms (fluorine, chloride, bromine, and iodine atoms), alkyl groups (linear, branched, or cyclic alkyl groups, which may be polycyclic alkyl groups such as bicycloalkyl groups or may contain an active methine group), alkenyl groups, alkynyl groups, aryl groups, heterocyclic groups (each heteroatom may be present in any position), acyl groups, alkoxycarbonyl groups, aryloxycarbonyl groups, heterocycle-oxycarbonyl groups, carbamoyl (substituted carbamoyl groups are, for example, N-hydroxycarbamoyl, N-acylcarbamoyl groups, N-sulfonylcarbamoyl groups, N-carbamoylcarbamoyl, thiocarbamoyl, and N-sulfamoylcarbamoyl), carbazoyl, carboxy or salts thereof, oxalyl, oxamoyl, cyano, carbonimidoyl, formyl, hydroxy, alkoxy groups (including ones containing repetitions of an ethyleneoxy or propyleneoxy group unit), aryloxy groups, heterocycle-oxy groups, acyloxy groups, (alkoxy or aryloxy)carbonyloxy groups, carbamoyloxy, sulfonyloxy groups, amino, (alkyl, aryl, or heterocycle) amino groups, acylamino groups, sulfonamido groups, ureido, thioureido, N-hydroxyureido, imido, (alkoxy or aryloxy)carbonylamino groups, sulfamoylamino, semicarbazido, thiosemicarbazido, hydrazino, ammonio, oxamoylamino, N-(alkylor aryl) sulfonylureido groups, N-acylureido groups, N-acylsulfamoylamino groups, hydroxyamino, nitro, heterocyclic groups containing a quaternized nitrogen atom (e.g., pyridinio, imidazolio, quinolinio, and isoquinolinio), isocyano, imino, mercapto, (alkyl, aryl, or heterocycle)thio groups, (alkyl, aryl, or heterocycle) dithio groups, (alkyl or aryl) sulfonyl groups, (alkyl or aryl) sulfinyl groups, sulfo or salts thereof, sulfamoyl (substituted sulfamoyl groups are, for example, N-acylsulfamoyl groups and N-sulfonylsulfamoyl groups) or salts thereof, phosphino, phosphinyl, phosphinyloxy, phosphinylamino, and silyl.

The term "active methine group" means a methine group substituted by two electron-attracting groups. The term "electron-attracting group" means, e.g., an acyl, alkoxycarbonyl, aryloxycarbonyl, carbamoyl, alkylsulfonyl, arylsulfonyl, sulfamoyl, trifluoromethyl, cyano, nitro, or carbonimidoyl group. The two electron-attracting groups may be bonded to each other to form a cyclic structure. The term "salt" means a salt with the cation of, e.g., an alkali metal, alkaline earth metal, or heavy metal or with an organic cation such as an ammonium ion or phosphonium ion.

Preferred of these substituents are, for example, halogen atoms (fluorine, chloride, bromine, and iodine atoms), alkyl groups (linear, branched, or cyclic alkyl groups, which may be polycyclic alkyl groups such as bicycloalkyl groups or may contain an active methine group), alkenyl groups, alkynyl groups, aryl groups, heterocyclic groups (each heteroatommay be present in anyposition), acyl groups, alkoxycarbonyl groups, aryloxycarbonyl groups, heterocycle-oxycarbonyl groups, carbamoyl, N-hydroxycarbomoyl, N-acylcarbamoyl groups, N-sulfonylcarbamoyl groups, N-carbamoylcarbamoyl, thiocarbamoyl, N-sulfamoylcarbamoyl, carbazoyl, oxalyl, oxamoyl, cyano, carbonimidoyl, formyl, hydroxy, alkoxy groups (including ones containing repetitions of an ethyleneoxy or propyleneoxy group unit), aryloxy groups, heterocycle-oxy groups, acyloxy groups, (alkoxy or aryloxy)carbonyloxy groups, carbamoyloxy, sulfonyloxy groups, (alkyl, aryl, or heterocycle)amino groups, acylamino groups, sulfonamido groups, ureido, thioureido, N-hydroxyureido, imido, (alkoxy or aryloxy)carbonylamino groups, sulfamoylamino, semicarbazido, thiosemicarbazido, hydrazino, ammonio, oxamoylamino, N--(alkyl or aryl)sulfonylureido groups, N-acylureido groups, N-acylsulfamoylamino groups, hydroxyamino, nitro, heterocyclic groups containing a quaternized nitrogen atom (e.g., pyridinio, imidazolio, quinolinio, and isoquinolinio), isocyano, imino, mercapto, (alkyl, aryl, or heterocycle) thio groups, (alkyl, aryl, or heterocycle) dithio groups, (alkyl or aryl) sulfonyl groups, (alkyl or aryl) sulfinyl groups, sulfo or salts thereof, sulfamoyl, N-acylsulfamoyl groups, N-sulfonylsulfamoyl groups or salts thereof, phosphino, phosphinyl, phosphinyloxy, phosphinylamino, and silyl. The term "active methine group" herein means a methine group substituted by two electron-attracting groups. Examples of the electron-attracting groups include acyl, alkoxycarbonyl, aryloxycarbonyl, carbamoyl, alkylsulfonyl, arylsulfonyl, sulfamoyl, trifluoromethyl, cyano, nitro, and carbonimidoyl groups.

More preferred examples of the substituents include halogen atoms (fluorine, chloride, bromine, and iodine atoms), alkyl groups (linear, branched, or cyclic alkyl groups, which may be polycyclic alkyl groups such as bicycloalkyl groups or may contain an active methine group), alkenyl groups, alkynyl groups, aryl groups, and heterocyclic groups (each heteroatom maybe present in anyposition).

The ring formed by R₁ and R₂ which are bonded to each other and by the -C-N- bond in formula (I) may be a monocycle or polycycle . Preferably, it is a 5- or 6-membered monocycle or a polycycle constituted of 5- or 6-membered rings.

Those substituents may have been substituted by any of those substituents.

The molecular weight of each compound represented by general formula (I) is preferably 20-600, more preferably 40-400.

Specific examples of the compounds represented by general formula (I) are shown below, but the compounds should not be construed as being limited to these examples.

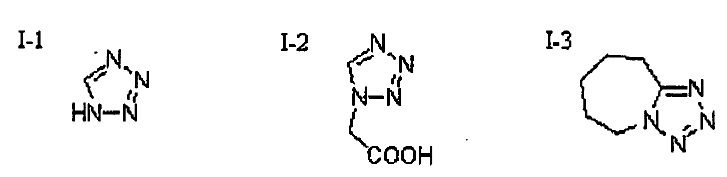

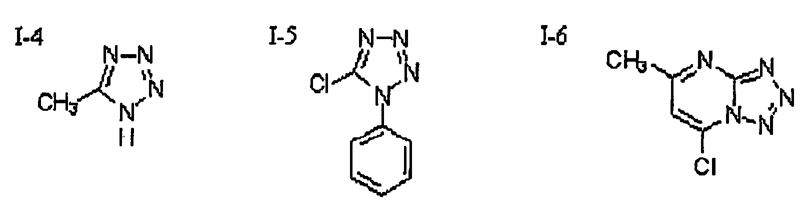

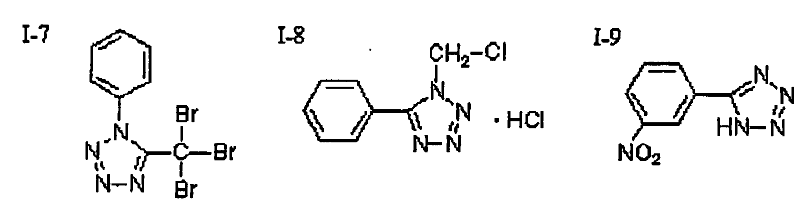

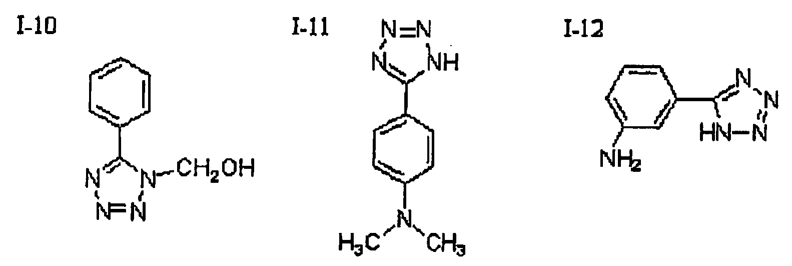

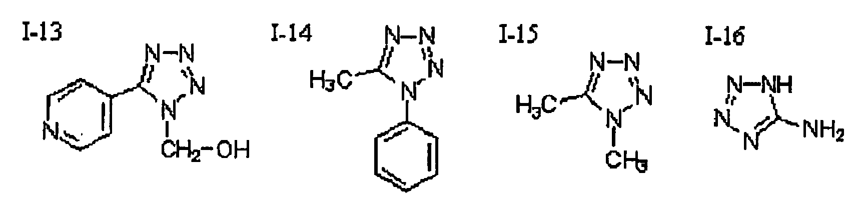

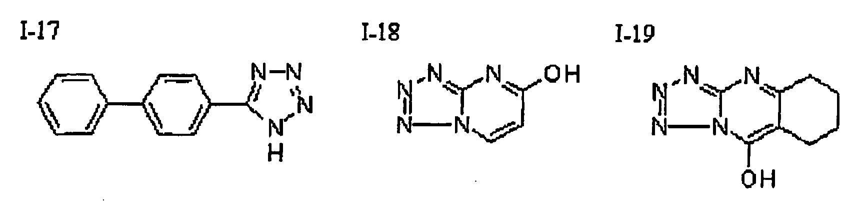

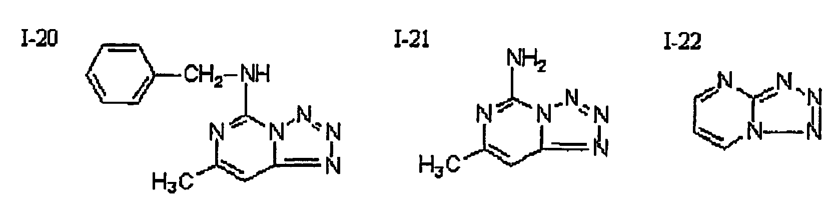

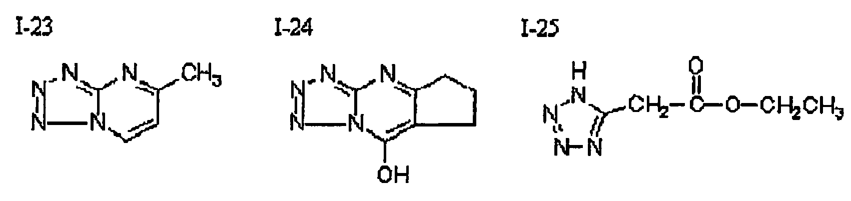

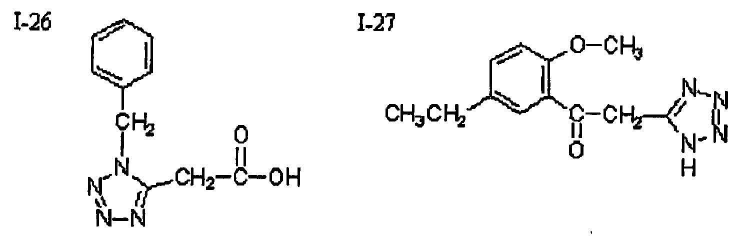

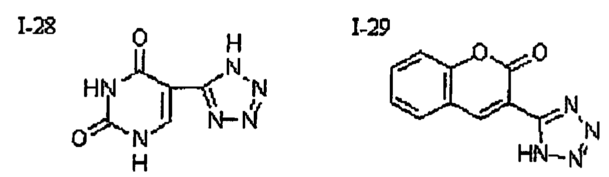

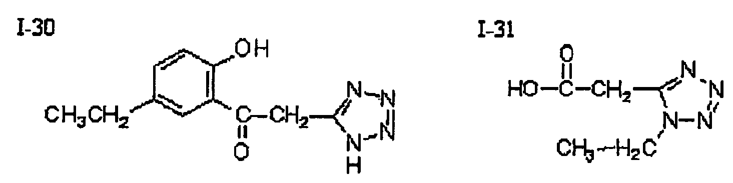

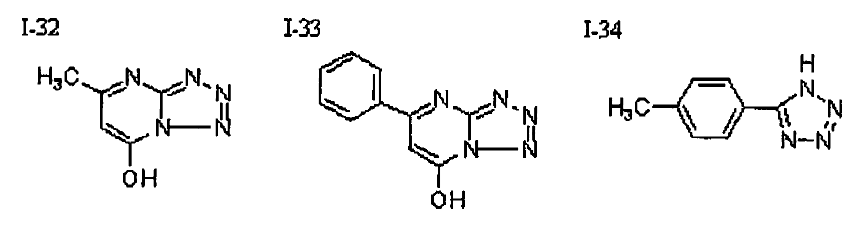

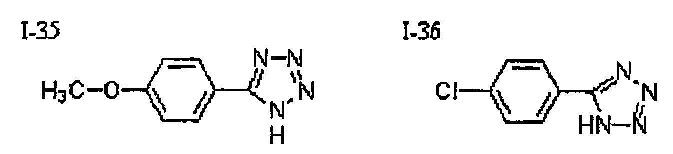

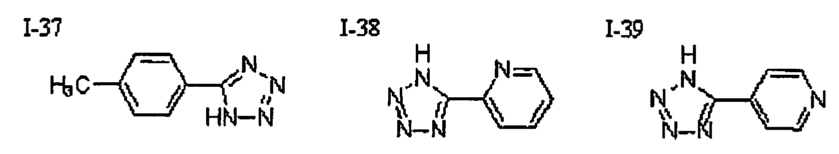

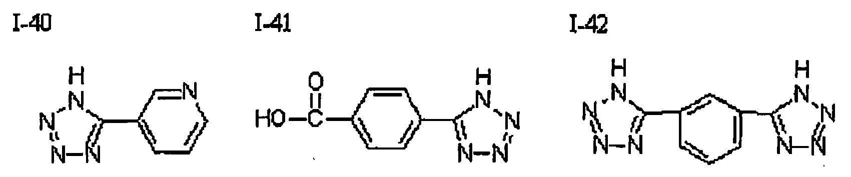

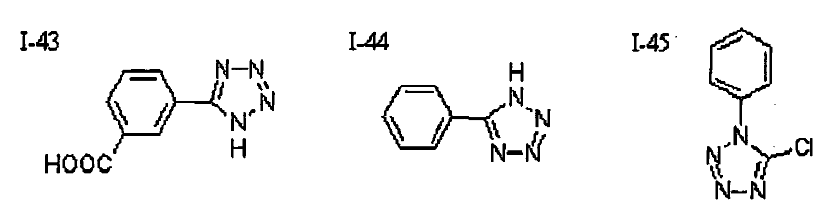

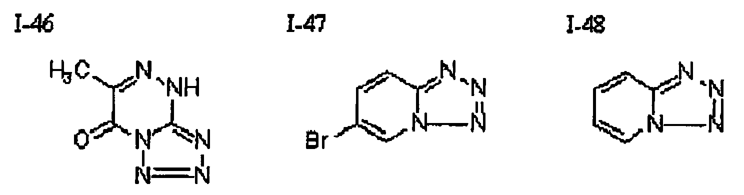

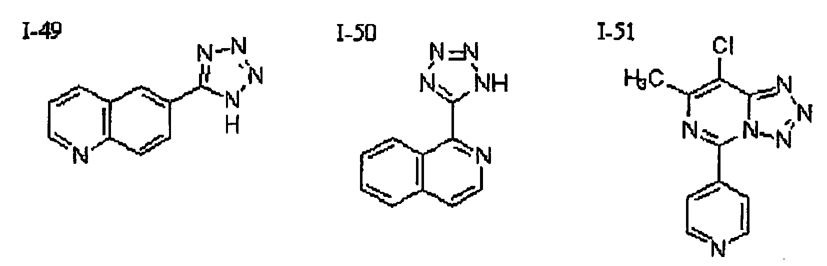

Preferred examples of the compounds represented by general formula (I) include compounds I-1, I-3, 1-4, I-10, I-15, I-21, I-22, I-23, I-41, and I-48. More preferred are compounds I-1, 1-4, I-15, I-22, and I-23.

The compounds represented by general formula (I) may be used alone or in combination of two or more thereof.

The compounds represented by general formula (I) can be synthesized by ordinary methods. Commercial products thereof may also be used.

The substituents represented by R₃ to R₈ in formula (II) are not particularly limited and examples thereof include the following.

Examples of the substituents represented by R₃ and R₈ include halogen atoms (fluorine, chloride, bromine, and iodine atoms), alkyl groups (linear, branched, or cyclic alkyl groups, which may be polycyclic alkyl groups such as bicycloalkyl groups or may contain an active methine group), alkenyl groups, alkynyl groups, aryl groups, heterocyclic groups (each heteroatom may be present in any position), acyl groups, alkoxycarbonyl groups, aryloxycarbonyl groups, heterocycle-oxycarbonyl groups, carbamoyl (substituted carbamoyl groups are, for example, N-hydroxycarbomoyl, N-acylcarbamoyl groups, N-sulfonylcarbamoyl groups, N-carbamoylcarbamoyl, thiocarbamoyl, and N-sulfamoylcarbamoyl), carbazoyl, carboxy or salts thereof, oxalyl, oxamoyl, cyano, carbonimidoyl, formyl, hydroxy, alkoxy groups (including ones containing repetitions of an ethyleneoxy or propyleneoxy group unit), aryloxy groups, heterocycle-oxy groups, acyloxy groups, (alkoxy or aryloxy)carbonyloxy groups, carbamoyloxy, sulfonyloxy groups, amino, (alkyl, aryl, or hetexocycle)amino groups, acylamino groups, sulfonamido groups, ureido, thioureido, N-hydroxyureido, imido, (alkoxy or aryloxy)carbonylamino groups, sulfamoylamino, semicarbazido, thiosemicarbazido, hydrazino, ammonio, oxamoylamino, N-(alkylor aryl) sulfonylureido groups, N-acylureido groups, N-acylsulfamoylamino groups, hydroxyamino, nitro, heterocyclic groups containing a quaternized nitrogen atom (e.g., pyridinio, imidazolio, quinolinio, and isoquinolinio), isocyano, imino, mercapto, (alkyl, aryl, or heterocycle) thio groups, (alkyl, aryl, or heterocycle) dithio groups, (alkyl or aryl) sulfonyl groups, (alkyl or aryl)sulfinyl groups, sulfo or salts thereof, sulfamoyl (substituted sulfamoyl groups are, for example, N-acylsulfamoyl groups and N-sulfonylsulfamoyl groups) or salts thereof, phosphino, phosphinyl, phosphinyloxy, phosphinylamino, and silyl.

The term "active methine group" means a methine group substituted by two electron-attracting groups. The term "electron-attracting group" means, e.g., an acyl, alkoxycarbonyl, aryloxycarbonyl, carbamoyl, alkylsulfonyl, arylsulfonyl, sulfamoyl, trifluoromethyl, cyano, nitro, or carbonimidoyl group. The two electron-attracting groups may be bonded to each other to form a cyclic structure. The term "salt" means a salt with the cation of, e.g., an alkali metal, alkaline earth metal, or heavy metal or with an organic cation such as an ammonium ion or phosphonium ion.

Those substituents may have been substituted by any of those substituents.

Preferred substituents of those are as follows. Preferably, at least one of R₃ to R₆ is a substituent which is not an unsubstituted alkyl group. More preferably, R₇ and R₈ each are a hydrogen atom. It is especially preferred that at least one of R₃ to R₆ be any of the electron-attracting groups enumerated above and R₇ and R₈ each be a hydrogen atom.

The cation represented by M⁺ is not particularly limited. Examples thereof include a hydrogen ion, alkali metal ions (e.g., Na⁺, K⁺, and Li⁺), and ammoniumions (e.g., NH₄⁺ and quaternary ammonium ions).

The molecular weight of each compound represented by general formula (II) is preferably 20-600, more preferably 40-400.

Specific examples of the compounds represented by general formula (II) are shown below, but the compounds should not be construed as being limited to these examples.

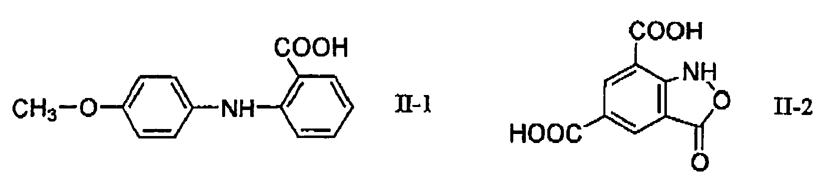

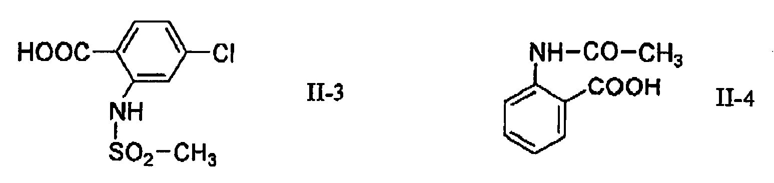

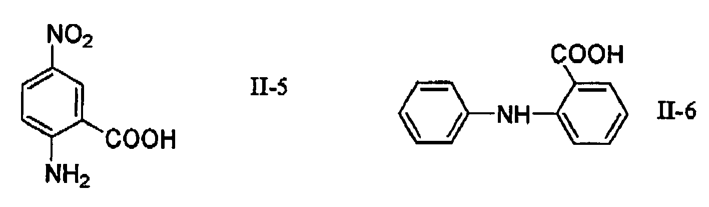

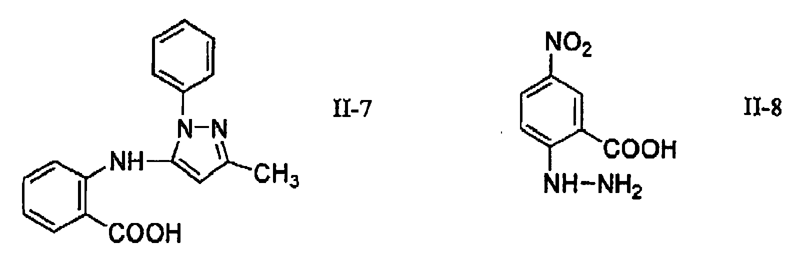

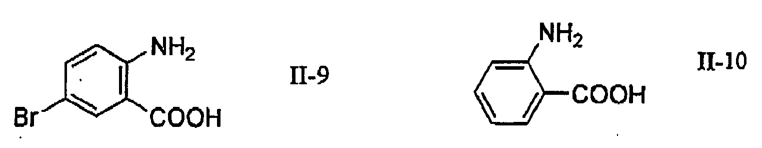

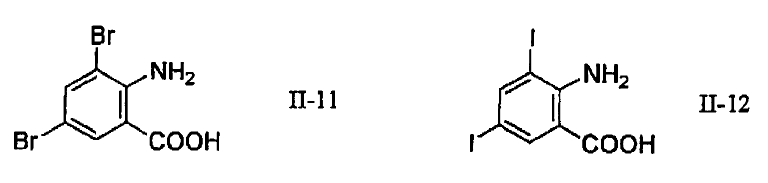

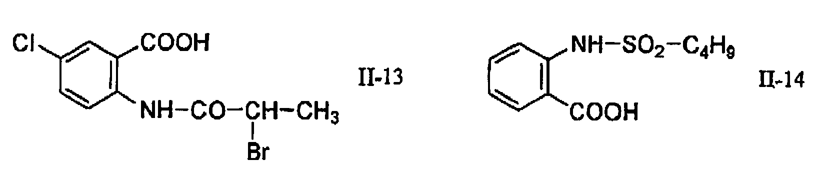

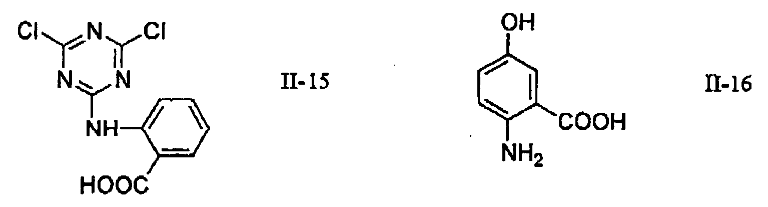

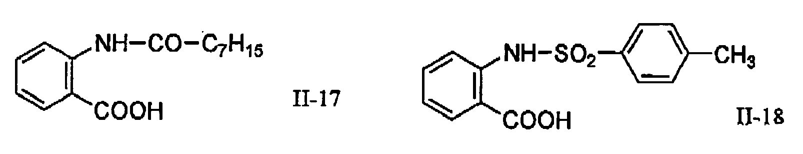

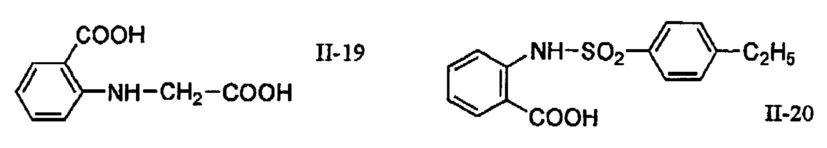

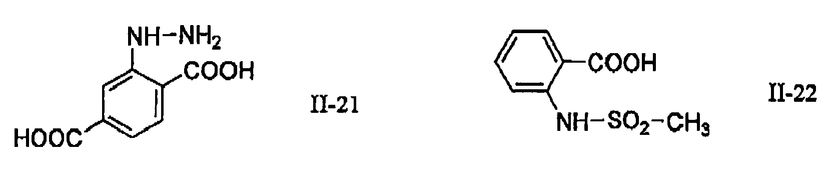

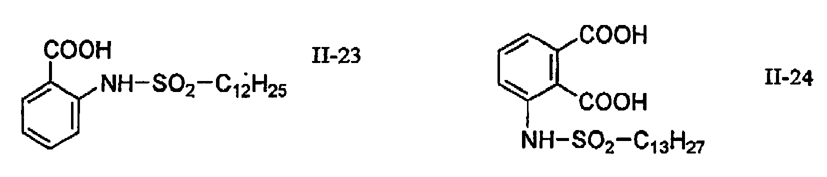

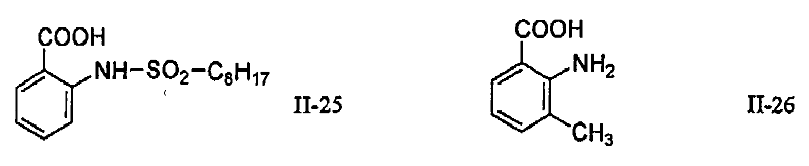

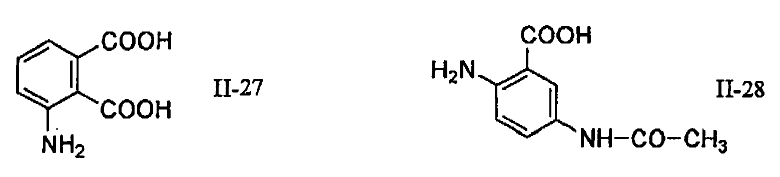

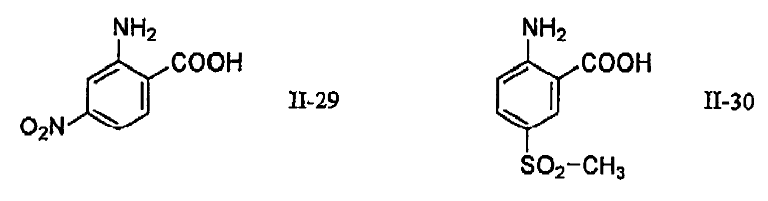

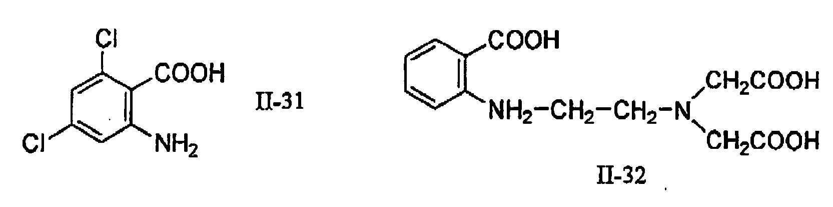

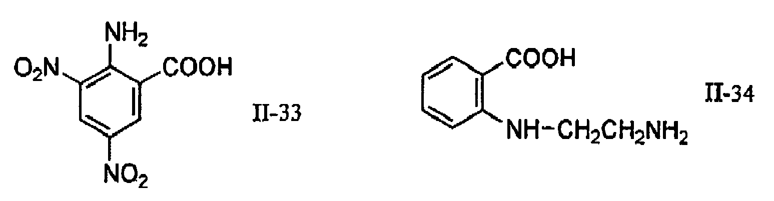

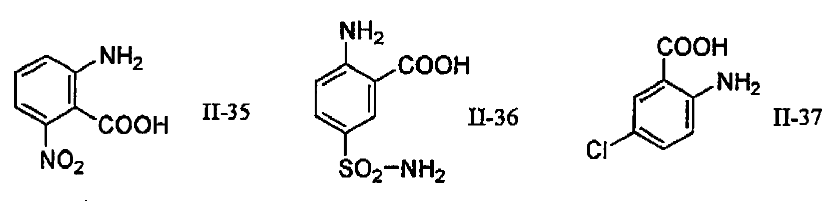

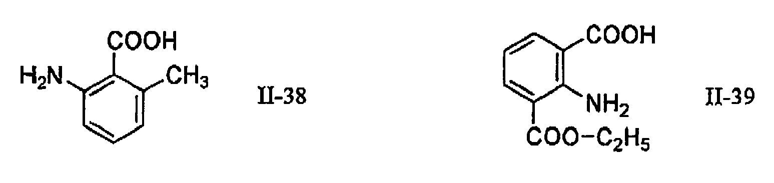

Preferred of these compounds are compounds II-2, II-5, II-9, II-27, II-29, II-30, II-33, II-35, and II-37. Especially preferred are compounds II-5, II-9, II-27, II-29, and II-33.

Examples of the compounds represented by general formula (II) further include the compounds shown above which each have been converted to a salt form by replacing the hydrogen atom(s) of the carboxy group(s) by an alkali metal ion such as Na⁺, K⁺, or Li⁺ or an ammonium ion such as NH₄⁺ or a quaternary ammonium ion.

The compounds represented by general formula (II) may be used alone or in combination of two or more thereof.

The compounds represented by general formula (II) to be usedmaybe commercial products or maybe ones synthesized by ordinary methods.

For example, compound II-29 can be synthesized by the synthesis method described in Synthesis (8), 654-659(1983). Compound II-37 can be synthesized by the methods described in *Tetrahedron Letters,* 51(7), 1861-1866(1995) and Tetrahedron Letters, 44 (25), 9791-4745 (2003) . Other compounds also can be synthesized according to methods described in these documents.

The total amount of the compound to be added, which is selected from tetrazole compounds and derivatives thereof and anthranilic acid compounds and derivatives thereof, is preferably 0.0001-1.0 mol, more preferably 0. 001-0.5 mol, even more preferably 0.01-0.1 mol, per L of the polishing composition in use for polishing (i.e., the diluted polishing composition when dilution with water or an aqueous solution is necessary; the same applies hereinafter to "polishing composition in use for polishing"). The reasons for this are as follows. The amount of the at least one compound selected from tetrazole compounds and derivatives thereof and anthranilic acid compounds and derivatives thereof is preferably 1.0 mol or smaller per L of the polishing composition from the standpoint of preventing the oxidizing agent and these compounds from deteriorating (coming to produce no effect or decomposing). From the standpoint of sufficiently obtaining the effect, the amount of the compound is preferably 0.0001 mol or larger.

A thiocyanic acid salt, thioether, thiosulfuric acid salt, or meso-ionic compound may also be added in an amount smaller than the addition amount of the at least one compound selected from tetrazole compounds and derivatives thereof and anthranilic acid compounds and derivatives thereof.

### (Oxidizing Agent)

The polishing composition of the invention contains a compound (oxidizing agent) capable of oxidizing the metal to be polished. Examples of the oxidizing agent include hydrogen peroxide, other peroxides, nitric acid salts, iodic acid salts, periodic acid salts, hypochlorous acid salts, chlorous acid salts, chloric acid salts, perchloric acid salts, persulfuric acid salts, dichromic acid salts, permanganic acid salts, ozonized water, silver(II) salts, and iron(III) salts.

Preferred examples of the iron (III) salts include inorganic iron(III) salts such as iron(III) nitrate, iron(III) chloride, iron(III) sulfate, and iron(III) bromide and organic complex salts of iron(III) .

In the case where an organic complex salt of iron(III) is used, examples of the complexing compound which is a component of the iron(III) complex salt include acetic acid, citric acid, oxalic acid, salicylic acid, diethyldithiocarbamic acid, succinic acid, tartaric acid, glycolic acid, glycine, alanine, aspartic acid, thioglycolic acid, ethylenediamine, trimethylenediamine, diethylene glycol, triethylene glycol, 1,2-ethanedithiol, malonic acid, glutaric acid, 3-hydroxybutyric acid, propionic acid, phthalic acid, isophthalic acid, 3-hydroxysalicyclic acid, 3,5-dihydroxysalicyclic acid, gallic acid, benzoic acid, maleic acid, and salts of these. Examples thereof further include aminopolycarboxylic acids and salts thereof.

Examples of the aminopolycarboxylic acids and salts thereof include ethylenediamine-N,N,N',N'-tetraacetic acid, diethylenetriaminepentaacetic acid, 1,3-diaminopropane-N,N,N',N'-tetraacetic acid, 1,2-diaminopropane-N,N,N',N'-tetraacetic acid, ethylenediamine-N,N'-disuccinic acid (racemate), ethylenediaminedisuccinic acid (SS isomer), N-(2-carboxylatoethyl)-L-aspartic acid, N-(carboxymethyl)-L-aspartic acid, β-alaninediacetic acid, methyliminodiacetic acid, nitrilotriacetic acid, cyclohexanediaminetetraacetic acid, iminodiacetic acid, (glycol ether)diaminetetraacetic acids, ethylenediamine-N,N'-diacetic acid, ethylenediamine-o-hydroxyphenylacetic acid, N,N-bis(2-hydroxybenzyl)ethylenediamine-N,N-diacetic acid, and salts of these. The kinds of the corresponding salts preferably are alkali metal salts and ammonium salts. Ammonium salts are especially preferred.

Preferred of these are hydrogen peroxide, iodic acid salts, hypochlorous acid salts, chloric acid salts, and organic complex salts of iron(III). In the case where an organic complex salt of iron (III) is used, preferred examples of the complexing compound include citric acid, tartaric acid, and aminopolycarboxylic acids (e.g., ethylenediamine-N,N,N',N'-tetraacetic acid, diethylenetriaminepentaacetic acid, 1,3-diaminapropane-N,N,N',N'-tetraacetic acid, ethylenediamine-N,N'-disuccinic acid (racemate), ethylenediaminedisuccinic acid (SS isomer), N- (2-carboxylatoethyl)-L-aspartic acid, N-(carboxymethyl)-L-aspartic acid, β-alaninediacetic acid, methyliminodiacetic acid, nitrilotriacetic acid, and iminodiacetic acid).

Most preferred of such oxidizing agents are hydrogen peroxide and iron (III) complexes of ethylenediamine-N,N,N',N'-tetraacetic acid, 1,3-diaminopropane-N,N,N',N'-tetraacetic acid, and ethylenediaminedisuccinic acid (SS isomer).

The amount of the oxidizing agent to be added is preferably 0.003-8 mol, more preferably 0.03-6 mol, especially preferably 0.1-4 mol, per L of the polishing composition in use for polishing. This is because the amount of the oxidizing agent to be added is preferably 0.003 mol or larger from the standpoint of securing sufficient metal oxidation and a high CMP rate and is preferably 8 mol or smaller from the standpoint of preventing the work surface from being roughened. (Acid)

It is preferred that the polishing composition of the invention should further contain an acid. This acid is a compound which differs in structure from the oxidizing agent for metal oxidation, and does not imply any acid which functions as the oxidizing agent described above. The acid here serves to accelerate oxidation and regulate the pH and functions as a buffer.

Examples of the acid in that range include inorganic acids, organic acids, and amino acids.

Examples of the inorganic acids include sulfuric acid, nitric acid, boric acid, and phosphoric acid. Preferred of such inorganic acids is phosphoric acid.

It is especially preferred in the invention that an organic acid or a salt thereof, or an amino acid be present. More preferably, an amino acid is present.

The organic acid or a salt thereof desirably is awater-soluble one. More suitable ones are selected from the following group: formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, salts of these acids, such as ammonium salts and alkali metal salts, ammonia, ammonium salts, mixtures of two or more of these, and the like. Formic acid, malonic acid, malic acid, tartaric acid, and citric acid are preferred of theses because they are suitable for multilayered films including a layer of at least one metal selected from copper, copper alloys, and copper alloy oxides.

The amino acid preferably is a water-soluble one. More suitable ones are selected from the following group.

Amino acids such as glycine, L-alanine, β-alanine, L-2-aminobutyric acid, L-norvaline, L-valine, L-leucine, L-norleucine, L-isoleucine, L-alloisoleucine, L-phenylalanine, L-proline, sarcosine, L-ornithine, L-lysine, taurine, L-serine, L-threonine, L-allothreonine, L-homoserine, L-tyrosine, 3,5-diiodo-L-tyrosine, β-(3,4-dihydroxyphenyl)-L-alanine, L-thyroxine, 4-hydroxy-L-proline, L-cysteine, L-methionine, L-ethionine, L-lanthionine, L-cystathionine, L-cystine, L-cysteic acid, L-aspartic acid, L-glutamic acid, S-(carboxymethyl)-L-cysteine, 4-aminobutyric acid, L-asparagine, L-glutamine, azaserine, L-arginine, L-canavanine, L-citrulline, δ-hydroxy-L-lysine, creatine, L-kynurenine, L-histidine, 1-methyl-L-histidine, 3-methyl-L-hystidine, ergothioneine, L-triptophan, actinomycin C1, apamin, angiotensin I, angiotensin II, and antipine.

In particular, malic acid, tartaric acid, citric acid, glycine, and glycolic acid are preferred because the rate of etching can be effectively reduced while maintaining a practical CMP rate.

The amount of the acid to be added is preferably 0.0005-0.5 mol, more preferably 0.005-0.3 mol, especially preferably 0.01-0.1 mol, per L of the polishing composition in use for polishing. This is because the amount of the acid to be added is preferably 0.5 mol or smaller from the standpoint of etching inhibition and is preferably 0.0005 mol or larger from the standpoint of obtaining a sufficient effect.

### (Chelating Agent)

The polishing composition of the invention preferably contains a chelating agent (i.e., water softener) according to need so as to diminish adverse influences of polyvalent metal ions and the like which come into the composition.

Examples of the chelating agent include general water softeners for use as anti-precipitants for calcium and magnesium and analogues of the softeners. Specific examples thereof include nitrilotriacetic acid, diethylenetriaminepentaacetic acid, ethylenediaminetetraacetic acid, N,N,N-trimethylenephosphonic acid, ethylenediamine-N,N,N',N'-tetramethylenesulfonic acid, trans-cyclohexanediaminetetraacetic acid, 1,2-diaminopropanetetraacetic acid, (glycol ether)diaminetetraacetic acid, ethylenediamine-o-hydroxyphenylacetic acid, ethylenediaminedisuccinic acid (SS isomer), N-(2-carboxylatoethyl)-L-aspartic acid, β-alaninediacetic acid, 2-phosphonobutane-1,2,4-tricarboxylic acid, 1-hydroxyethyZidene-1, 1--diphosphonic acid, N,N'-bis(2-hydroxybenzyl)ethylenediamine-N,N'-diacetic acid, and 1,2-dihydroxybenzene-4,6-disulfonic acid.

Two or more chelating agents may be used in combination according to need.

The amount of the chelating agent to be added is not particularly limited as long as it is sufficient to block polyvalent and other metal ions coming into the composition. For example, the chelating agent is added in an amount of 0.0003-0.07 mol per L of the polishing composition in use for polishing..

### [Additives]

It is preferred to use the following additives in the polishing composition of the invention.

Examples of usable additives include ammonia; amines such as alkylamines, e.g., dimethylamine, trimethylamine, triethylamine, and propylenediamine, ethylenediaminetetraacetic acid (EDTA), sodium diethyl dithiocarbamate, and chitosan; imines such as dithizone, cuproine (2,2'-biquinoline), neocuproine (2,9-dimethyl-1,10-phenanthroline), bathocuproine (2,9-dimethyl-4,7-diphenyl-1,10-phenanthroline), and cuperazone (biscyclohexanone oxalylhydrazone); azoles such as benzimidazole-2-thiol, 2-[2-(benzothiazolyl)]thiopropionic acid, 2-[2-(benzothiazolyl)]thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxy-1H-benzotriazole, 4-methoxycarbonyl-1H-benzotriazole, 4-butoxycarbonyl-1H-benzotriazole, 4-octyloxycarbonyl-1H-benzotriazole, 5-hexylbenzotriazole, N-(1,2,3-benzotriazolyl-1-methyl)-N-(1,2,4-triazolyl-1-ntethyl) -2-ethylhexylamine, tolyltriazole, naphthotriazole, and bis[(1-benzotriazolyl)methyl]phosphonic acid; mercaptans such as nonyl mercaptan, dodecyl mercaptan, triazinethiol, triazinedithiol, and triazinetrithiol; and quinaldic acid. Preferred of these are chitosan, ethylenediaminetetraacetic acid, L-tryptophan, cuperazone, triazinedithiol, benzotriazole, 4-hydroxybenzotriazole, 4-carboxy-1H-benzotriazole butyl ester, tolyltriazole, and naphthotriazole from the standpoint of attaining both a high CMP rate and a low etching rate.

The amount of such additives to be added is preferably 0.0001-0.5 mol,more preferably0.001-0.2 mol,especiallypreferably 0.005-0.1 mol, per Lof thepolishing composition in use for polishing. This is because the amount of the additives to be added is preferably 0.0001 mol or larger from the standpoint of etching inhibition and is preferably 0.5 mol or smaller from the standpoint of preventing the CMP rate from decreasing.

### [Surfactant and/or Hydrophilic Polymer]

The polishing composition of the invention preferably contains a surfactant and/or a hydrophilic polymer. A surfactant and a hydrophilic polymer each serve to reduce the contact angle with work surfaces and thereby promote even polishing. The surfactant and/or hydrophilic polymer to be used preferably is one selected from the following groups.

Examples of anionic surfactants include carboxylic acid salts, sulfonic acid salts, sulfuric acid ester salts, and phosphoric acid ester salts. Examples of the carboxylic acid salts include soaps, N-acylamino acid salts, (polyoxyethylene or polyoxypropylene alkyl ether) carboxylic acid salts, and acylated peptides. Examples of the sulfonic acid salts include alkylsulfonic acid salts, alkylbenzene- and alkylnaphthalenesulfonic acid salts, naphthalenesulfonic acid salts, sulfosuccinic acid salts, α-olefinsulfonic acid salts, and N-acylsulfonic acid salts. Examples of the sulfuric acid ester salts include sulfonated oils, alkylsulfuric acid salts, alkyl ether sulfuric acid salts, polyoxyethylene or polyoxypropylene alkylaryl ether sulfuric acid salts, and alkylamide sulfuric acid salts. Examples of the phosphoric acid ester salts include alkylphosphoric acid salts and polyoxyethylene or polyoxypropylene alkylaryl ether phosphoric acid salts.

Examples of cationic surfactants include aliphatic amine salts, aliphatic quaternary ammonium salts, benzalkonium chloride salts, benzethonium chloride, pyridinium salts, and imidazolinium salts. Examples of amphoteric surfactants include the carboxybetaine type, aminocarboxylic acid salts, imidazolinium betaines, lecithin, and alkylamine oxides.

Examples of nonionic surfactants include the ether type, ether ester type, ester type, and nitrogen-containing type. Examples of the ether type include polyoxyethylene alkyl and alkylphenyl ethers, alkylaryl/formaldehyde condensate polyoxyethylene ethers, polyoxyethylene/polyoxypropylene block polymers, and polyoxyethylene/polyoxypropylene alkyl ethers. Examples of the ether ester type include polyoxyethylene ethers of glycerol esters, polyoxyethylene ethers of sorbitan esters, and polyoxyethylene ethers of sorbitol esters. Examples of the ester type include polyethylene glycol fatty acid esters, glycerol esters, polyglycerol esters, sorbitan esters, propylene glycol esters, and sucrose esters. Examples of the nitrogen-containing type include fatty acid alkanolamides, polyoxyethylene fatty acid amides, and polyoxyethylene alkylamides.

Examples of the surfactant further include fluorochemical surfactants.

Examples of other surfactants and hydrophilic compounds and examples of the hydrophilic polymer and the like include esters such as glycerol esters, sorbitan esters, methoxyacetic acid, ethoxyacetic acid, 3-ethoxypropionic acid, and alanine ethyl ester; ethers such as polyethylene glycol, polypropylene glycol, polytetramethylene glycol, polyethylene glycol alkyl ethers, polyethylene glycol alkenyl ethers, alkylpolyethylene glycols, alkylpolyethylene glycol alkyl ethers, alkylpolyethylene glycol alkenyl ethers, alkenylpolyethylene glycols, alkenylpolyethylene glycol alkyl ethers, alkenylpolyethylene glycol alkenyl ethers, polypropylene glycol alkyl ethers, polypropylene glycol alkenyl ethers, alkylpolypropylene glycols, alkylpolypropylene glycol alkyl ethers, alkylpolypropylene glycol alkenyl ethers, alkenylpolypropylene glycols, alkenylpolypropylene glycol alkyl ethers, and alkenylpolypropylene glycol alkenyl ethers; polysaccharides such as alginic acid, pectic acid, carboxymethyl cellulose, curdlan, and pullulan; amino acid salts such as glycine ammonium salt and glycine sodium salt; polycarboxylic acids and salts thereof, such as poly(aspartic acid), poly(glutamic acid), polylysine, poly(malic acid), poly(methacrylic acid), poly (methacrylic acid) ammonium salt,poly(methacrylic acid) sodium salt, poly(amic acid), poly(maleic acid), poly(itaconic acid), poly(fumaric acid), poly(p-styrenecarboxyilc acid), poly(acrylic acid), polyacrylamide, aminopolyacrylamide, poly(acrylic acid) ammonium salt, poly(acrylic acid) sodium salt, poly(amic acid), poly(amic acid) ammonium salt, poly(amic acid) sodium salt, and poly(glyoxylic acid); vinyl polymers such as poly (vinyl alcohol), polyvinylpyrrolidone, and polyacrolein; sulfonic acids and salts thereof, such as methyltaurine acid ammonium salt, methyltaurine acid sodium salt, sodium methyl sulfate, ammonium ethyl sulfate, ammonium butyl sulfate, sodium vinylsulfonate, sodium 1-allylsulfonate, sodium 2-allylsulfonate, sodium methoxymethylsulfonate, ammonium ethoxymethylsulfonate, sodium 3-ethoxypropylsulfonate, sodium methoxymethylsulfonate, ammonium ethoxymethylsulfonate, sodium 3-ethoxypropylsulfonate, and sodium sulfosuccinate; and amides such as propionamide, acrylamide, methylurea, nicotinamide, succinamide, and sulfanilamide.

However, in the case where the substrate to which the polishing composition is to be applied is, e.g., a silicon substrate for semiconductor integrated circuits, fouling by alkali metals, alkaline earth metals, halides, or the like is undesirable. It is therefore desirable to use an acid or its ammonium salt in this case. This does not apply when the substrate is, e.g., a glass substrate. More preferred of the compounds shown above as examples are cyclohexanol, poly(acrylic acid) ammonium salt, poly(vinyl alcohol), succinamide, polyvinylpyrrolidone, polyethylene glycol, and polyoxyethylene/polyoxypropylene block copolymers.

The total amount of the surfactant and/or hydrophilic polymer to be added is preferably 0.001-10 g, more preferably 0.01-5 g, especially preferably 0.1-3 g, per L of the polishing composition in use for polishing. This is because the amount of the surfactant and/or hydrophilic polymer to be added is preferably 0.001 g or larger from the standpoint of obtaining a sufficient effect and is preferably 10 g or smaller from the standpoint of preventing the CMP rate from decreasing. The weight-average molecular weight of each of those surfactants and/or hydrophilic polymers is preferably 500-100,000, especially preferably 2,000-50,000.

### [Alkali Agent and Buffer]

The metal-polishing liquid of the invention can contain an alkali agent for pH regulation and a buffer for diminishing pH fluctuations according to need.

As the alkali agent and buffer can be used nonmetal alkali agents such as ammonium hydroxide, organic ammonium hydroxides, e.g., tetramethylammonium hydroxide, and alkanolamines, e.g., diethanolamine, triethanolamine, and triisopropanolamine, alkali metal hydroxides such as sodium hydroxide, potassium hydroxide, and lithium hydroxide, carbonic acid salts, phosphoric acid salts, boric acid salts, tetraboric acid salts, hydroxybenzoic acid salts, glycyl salts, N,N-dimethylglycine salts, leucine salts, norleucine salts, guanine salts, 3,4-dihydroxyphenylalanine salts, alanine salts, aminobutyric acid salts, 2-amino-2-methyl-1,3-propanediol salts, valine salts, proline salts, trishydroxyaminomethane salts, lysine salts, and the like.

Specific examples of the alkali agent and buffer include sodium hydroxide, potassium hydroxide, lithium hydroxide, sodium carbonate, potassium carbonate, sodium hydrogen carbonate, potassium hydrogen carbonate, trisodium phosphate, tripotassium phosphate, disodium phosphate, dipotassium phosphate, sodiumborate, potassiumborate, sodium tetraborate(borax),potassium tetraborate, sodium o-hydroxybenzoate (sodium salicylate), potassium o-hydroxybenzoate, sodium 5-sulfo-2-hydroxybenzoate (sodium 5-sulfosalicylate), potassium 5-sulfo-2-hydxoxybenzoate (potassium 5-sulfosalicylate), and ammonium hydroxide.

Especially preferred alkali agents are ammonium hydroxide, potassium hydroxide, lithium hydroxide, and tetramethylammonium hydroxide.

The amount of the alkali agent and buffer to be added is not particularly limited as long as the pH of the polishing composition is kept in a preferred range. The amount thereof is preferably 0.0001-1.0 mol, more preferably 0. 003-0.5 mol, per L of the polishing composition in use for polishing.

The pH of the polishing composition in use for polishing is preferably 2-14, more preferably 3-12, most preferably 3.5-8. When the pH of the polishing composition of the invention is in this range, the composition produces especially excellent effects.

It is preferred in the invention that the kinds and amounts of the compounds to be added and the pH of the composition should be suitably determined according to adsorbability to the surface to be polished, reactivity, solubility of the metal to be polished, electrochemical properties of the surface to be polished, dissociated state of the functional groups of the compounds, stability of the liquid, etc.

In the case where a concentrate is prepared, the amount of each ingredient having a solubility in room-temperature water less than 5%, among the ingredients to be added, is regulated to preferably up to 2 times, more preferably up to 1.5 times, the solubility in room-temperature water from the standpoint of preventing the concentrate from suffering precipitation when cooled to, e.g., 5°C.

### [Material of Wiring Metal]

In the invention, preferred examples of the material to be polished include wirings made of copper metal and/or a copper alloy in the production of semiconductor devices such as, e.g., LSIs. Especially preferred are wirings made of copper alloys. Preferred of copper alloys are copper alloys containing silver. The content of silver in such copper alloys is preferably 40% by mass or lower, especially 10% by mass or lower, even more preferably 1% by mass or lower. The invention produces the highest effects when applied to copper alloys having a silver content in the range of 0.00001-0.1% by mass.

### [Line Thickness of Wiring]

In the invention, the semiconductor device to be polished preferably is as follows. In the case where the device is, e.g., a DRAM device, it preferably is an LSI having a wiring with a line width of 0.15 µm or smaller, especially 0.10 µm or smaller, more preferably 0.08 µm or smaller, in terms of half pitch. On the otherhand, in the case where the device is an MPU device, it preferably is an LSI having a wiring with a line width of 0.12 µm or smaller, especially 0.09 µm or smaller, more preferably 0.07 µm or smaller. When applied to these LSIs, the polishing liquid of the invention produces especially excellent effects.

### [Barrier Metal]

The semiconductor device to be polished in the invention preferably is one in which a barrier layer for preventing copper diffusion has been interposed between the wiring made of copper metal and/or a copper alloy and an interlayer dielectric. The material of the barrier layer preferably is a metallic material having low resistance. Preferred are TiN, TiW, Ta, TaN, W, and WN. Especially preferred of these are Ta and TaN.

### [Method of Polishing]

There are cases where the polishing composition has been produced as a concentrate and is diluted with water at time of use to prepare a liquid to be used, or where the ingredients are supplied as aqueous solutions which will be described later. in the latter case, these aqueous solutions are mixed together and optionally diluted with water to prepare a liquid to be used. There also are cases where the polishing composition has been prepared as a liquid to be used. The polishing method employing the polishing composition of the invention is applicable to all these cases. It is a polishing method which comprises supplying the polishing liquid to a polishing pad disposed on a polishing surface plate and moving the polishing pad relatively to a surface to be polished, while keeping the polishing liquid in contact with the surface, to thereby polish the surface.

As an apparatus for polishing, use can be made of a general polishing apparatus having a holder which holds a semiconductor substrate or the like having a surface to be polished and a polishing surface plate having a polishing pad attached thereto (and equipped with a motor capable of changing in rotation speed) . The polishing pad is not particularly limited, and use can be made of general nonwoven fabrics, foamed polyurethanes, porous fluororesins, and the like. There are no limitations on polishing conditions. However, the rotation speed of the polishing surface plate is preferably a low speed of 200 rpm or lower so as to prevent the substrate from going out. The pressure at which the semiconductor substrate having a surface to be polished (film to be polished) is pressed against the polishing pad is preferably 5-500 g/cm². The pressure is more preferably 12-240 g/cm² from the standpoint of satisfying the evenness of polishing rate throughout the whole wafer surface and pattern planarization.

During polishing, the polishing composition is continuously supplied to the polishing pad with a pump or the like. Although the rate of this supply is not particularly limited, it is preferred that the surface of the polishing pad be always covered with the polishing liquid. After completion of the polishing, the semiconductor substrate is sufficiently washed in running water, subsequently treated with a spin dryer or the like to remove water drops adherent to the semiconductor substrate, and then dried. In the polishing method of the invention, the aqueous solution to be used for dilution is the same as the aqueous solution described below. The aqueous solution is water into which at least one of oxidizing agents, acids, additives, and surfactants has been incorporated in such an amount that the sum of the ingredients thus incorporated in the aqueous solution and the ingredients contained in the polishing composition to be diluted is equal to the ingredients to be contained in the polishing composition in use for polishing. In the case where the polishing composition is diluted with an aqueous solution at time of use, the polishing composition can be prepared in a more concentrated form because an ingredient difficult to dissolve can be incorporated in the form of an aqueous solution.

For adding water or an aqueous solution to the concentrated polishing composition to dilute the composition, use may be made of a method in which a piping for supplying the concentrated polishing composition is caused, before reaching the polishing pad, to meet a piping for supplying water or an aqueous solution to thereby mix the two flows and the polishing composition thus diluted by mixing is supplied to the polishing pad. For the mixing can be employed a technique in general use, such as, e.g., a method in which the two liquids in a pressurized state are passed through narrow passages and caused to collide and mix with each other, a method in which a packing, e.g., glass pipes, is packed into a piping to cause the liquid flows to repeatedly undergo separation and confluence, or a technique in which blades rotating under power are disposed in a piping.

The rate of supplying the polishing composition is preferably 10-1,000 mL/min, and is more preferably 170-800 mL/min from the standpoint of satisfying the evenness of polishing rate throughout the whole wafer surface and pattern planarization.

For diluting the concentrated polishing composition with water, an aqueous solution, or the like and polishing a work surface, use may be made of a method in which a piping for supplying the polishing composition and a piping for supplying water or an aqueous solution are independently disposed and the two liquids are supplied to the polishing pad through the respective pipings in given amounts. In this method, the two liquids are mixed with each other by the relative movement of the polishing pad and the work surface and the surface is polished simultaneously with this mixing. Alternatively, use may be made of a method in which the concentrated polishing composition and either water or an aqueous solution are introduced in given amounts into one vessel and mixed with each other and the polishing composition obtained by the mixing is supplied to the polishing pad to conduct polishing.

A still another embodiment of the polishing method of the invention is as follows. The ingredients to be contained in the polishing composition are divided into at least two components. These components are diluted with water or an aqueous solution at time of use, and the dilutions are supplied to the polishing pad on a polishing surface plate and brought into contact with a work surface . The work surface is moved relatively to the polishing pad to thereby polish the surface.

For example, an oxidizing agent is used as one component (A), and an acid, additives, a surfactant, and water are used as another component (B). At time of use, component (A) and component (B) are diluted with water or an aqueous solution.

Alternatively, lowly soluble additives are divided into two components (A) and (B) in the following manner. An oxidizing agent, additives, and a surfactant are used as one component (A), and an acid, additives, a surfactant, and water are used as another component (B). At time of use, component (A) and component (B) are diluted with water or an aqueous solution. In this embodiment, three pipings are necessary for supplying component (A), component (B), and water or an aqueous solution, respectively. The dilution and mixing can be accomplished by a method in which the three pipings are connected to one piping extending to the polishing pad and the three liquids are mixed together in this piping. In this case, it is possible to cause two pipings to meet each other first and the remaining one piping to meet these thereafter.

For example, it is a method in which a component including an additive difficult to dissolve is mixed with another component and, after a dissolution period secured with an elongated mixing passage, the piping for water or an aqueous solution is caused to meet it. The other methods are: a method in which the three pipings are directly introduced to a polishing pad and the three liquids are mixed together by the relative movement of the polishing pad and the work surface, as described above; and a method in which the three components are mixed with one another in one vessel and the resultant diluted polishing composition is supplied from this vessel to a polishing pad. The polishing methods described above canbe conducted in the followingmanner . The one component including an oxidizing agent is kept at 40°C or lower and another component is heated at a temperature in the range of from room temperature to 100°C. Furthermore, temperature regulation is conducted so that when the one component is mixed with the other component or with water or an aqueous solution, then the resultant dilution has a temperature of 40°C or lower. Since higher temperatures result in increased solubility, this method is preferred from the standpoint of increasing the solubility of less soluble rawmaterials for the polishing composition.

The ingredients excluding an oxidizing agent which have been dissolved with heating at a temperature in the range of from room temperature to 100 °C precipitate in the solution with decreasing temperature. Because of this, in the case where these ingredients whose temperature has decreased are used, it is necessary to conduct heating to dissolve the precipitate beforehand. This canbe attained by employing a means for sending the solution obtained by dissolving the component with heating or a means for stirring the precipitate-containing liquid and sending this liquid through a heated piping to dissolve the precipitate. In case where the one component including an oxidizing agent is heated to a temperature of 40°C or higher by a heated component, there is a possibility that the oxidizing agent might decompose. Because of this, the heated component and the oxidizing agent-including one component, which cools the heated component, are mixed with each other under such conditions that the resultant mixture has a temperature of 40°C or lower.

In the invention, the ingredients for the polishing composition may be supplied to a work surface after having been divided into two or more groups, as described above. In this case, it is preferred that the ingredients be divided into a component including the oxide and a component including the acid and these components be separately supplied. Furthermore, use may be made of a method in which the polishing composition is prepared as a concentrate and this concentrate and diluting water are separately supplied to a work surface. [Pad]

The pad for polishing may be either a pad having an unfoamed structure or a pad having a foamed structure. The former pad comprises a rigid synthetic-resin bulk material such as a plastic plate. Examples of the latter pad include the following three types: a closed-cell foam (dry-process foam), an open-cell foam (wet-process foam), and a two-layer composite (multilayer foam). Especially preferred is a two-layer composite (multilayer foam). Foaming may be even or uneven.

The pad may be one which contains abrasive grains for use in polishing (e.g., ceria, silica, alumina, or a resin). Those types of pads each include a rigid one and a flexible one, and either of these may be used. The multilayer foam preferably is one in which the layers differ in hardness. Preferred examples of materials include nonwoven fabrics, artificial leathers, polyamides, polyurethanes, polyesters, and polycarbonates. That surface of the pad which comes into contact with a work surface may be subjected to a processing for forming lattice grooves, holes, concentric grooves, a spiral groove, or the like therein. [Wafer]

The wafer to be subj ected to CMP with the polishing composition of the invention has a diameter of preferably 200 mm or larger, especially preferably 300 mm or larger. When the wafer diameter is 300 mm or larger, the effects of the invention are remarkably produced.

### [Examples]

The invention will be explained below by reference to Examples, but the invention should not be construed as being limited by these

### Examples.

### <Preparation of Abrasive Grains>

In a general method of synthesizing colloidal silica by the hydrolysis of an alkoxysilane, colloidal silicas differing in the degree of association were produced by changing raw-material addition conditions. The procedure was as follows. While a solution prepared by mixing methanol with ammonia, pure water, and a dispersant was being stirred at a constant temperature of 50°C or higher, a mixture of methyl orthosilicate and an organic solvent was mixed therewith at a dropping rate of 3 g/min, 26 g/min, or 54 g/min. Thus, abrasive grain materials (1), (2), and (3) were yielded. After the reaction and grain formation, the abrasive grain materials (1) to (3) were quenched by adding a large amount of methanol thereto. According to need, displacement by water solvent was conducted with an evaporator. Thus, the preparation of abrasive grain materials (1) to (3) was completed. (Measurement of Particle Sizes)

Part of each of abrasive grain materials (1) to (3) was diluted with a large amount of an alcohol. This dilution was dropped onto a mesh plate and dried. The resultant solid was examined with a TEM (transmission electron microscope) to measure the minor-axis lengths and major-axis lengths of 100 particles.

The results of the particle size measurements of the abrasive grain materials (1) to (3) are shown below.

Abrasive grains (1): monodisperse colloidal silica containing almost no associative particles and having a minor-axis diameter of 50-65 nm and an average major-axis length of 64 nm.

Abrasive grains (2): lowly associative colloidal silica having a minor-axis length of 50-65 nm and an average major-axis length of 77 nm (degree of association: 2.3).

Abrasive grains (3): highly associative colloidal silica having a minor-axis length of 50-65 nm and an average major-axis length of 92 nm (degree of association: 3.5).

### <EXAMPLE 1>

A water-based polishing liquid containing the following ingredients was prepared and evaluated under the polishing conditions shown below.

### (Preparation of Polishing Liquid)

| | |
|---|---|
| Abrasive grains (2) (abrasive particles) | 40 g/L (on solid basis) |
| 1H-Tetrazole (protective-film-forming agent) | 0.1 g/L |
| Hydrogen peroxide (oxidizing agent) | 10 g/L |
| Glycine (acid) | 8 g/L |
| pH | 7.0 |

### (Polishing Conditions)

Work: 8-inch silicon wafer plated with copper
Polishing pad: IC1400 (Rodel Nitta Company)
Polishing machine: LGP-612 (Lapma Ster SFT)
Polishing pressure: 2.5 pai
Slurry supply rate: 200 mL/min
work rotation speed/polishing pad rotation speed: 64/65 rpm

### (Evaluation Methods)

### [Polishing Rate]

With respect to each of before and after the polishing, the thickness of the copper film on the wafer was determined by conversion from a value of electrical resistance. The average polishing rate was determined from the difference between these thickness values.

### [Scratching (damage to work surface)]

The pattern wafer surface which had undergone the polishing was examined with a microscope (MX80, manufactured by Olympus) to count the number of scratches formed.

Namely, a central part (5 cm x 5 cm) of each of five samples was examined at a magnification of 300 diameters. The cases where the average number of scratches, Sc, was Sc≤1, 1<Sc≤3, and 3<Sc are indicated by A, B, and C, respectively, in Table 1.

### <EXAMPLES 2 AND 3 AND COMPARATIVE EXAMPLES 1 TO 3>

Polishing liquids of Examples 2 and 3 and Comparative Examples 1 to 3 were prepared in the same manner as in Example 1, except that the abrasive grains and compounds shown in Table 1 were used in place of the polishing particles and protective-film-forming agent used in Example 1. A polishing test was conducted in the same manner as in Example 1.

The results obtained are shown in Table 1.

**Table 1**

| | Abrasive particles | Protective-film-forming agent | Polishing rate (nm/min) | Scratch -ing |
|---|---|---|---|---|
| Example 1 | Abrasive grains (2) | 1H-tetrazole | 940 | A |
| Example 2 | Abrasive grains (3) | 1H-tetrazole | 1060 | A |
| Example 3 | Abrasive grains (2) | methylanthranilic acid | 1040 | A |
| Comparative Example 1 | Abrasive grains (1) | 1H-tetrazole | 800 | A |
| Comparative Example 2 | Abrasive grains (2) | 1,2,3-benzotriazoie | 560 | C |
| Comparative Example 3 | Abrasive grains (1) | 1,2,3-benzotriazole | 440 | B |

It can be seen from Table 1 that the polishing liquids of Examples 1 to 3 had excellent performances with a high polishing rate and reduced scratching.

When the polishing composition of the invention is used as a polishing liquid for chemical mechanical polishing in the production of semiconductor devices, the in-plane evenness of the wafer is secured and the occurrence of defects accompanying local unevenness of polishing, such as, e.g., corrosion, thinning, and erosion, can be kept on a low level. In addition, the polishing composition has a high CMP rate and enables LSI production through CMP inhibited from causing dishing and scratching.

The entire disclosure of each and every foreign patent application from which the benefit of foreign priority has been claimed in the present application is incorporated herein by reference, as if fully set forth.

## Claims

1. A polishing composition comprising:
at least one compound selected from tetrazole compounds and derivatives thereof and anthranilic acid compounds and derivatives thereof;
abrasive particles comprising_associative abrasive particles; and
an oxidizing agent.

2. The polishing composition of claim 1, wherein the proportion of the associative abrasive particles is 10% by volume or higher based on all the abrasive particles.

3. The polishing composition of claim 1, wherein the proportion of the associative abrasive particles is 40% by volume or higher based on all the abrasive particles.

4. The polishing composition of claim 1, wherein the associative abrasive particles have an average major-axis length in the range of 10 to 300 nm and a degree of association higher than 1 and not higher than 10.

5. The polishing composition of claim 1, wherein the associative abrasive particles have an average major-axis length in the range of 10 to 300 nm and a degree of association in the range of 1.2 to 10.

6. The polishing composition of claim 1, wherein the associative abrasive particles have an average major-axis length in the range of 10 to 300 nm and a degree of association in the range of 1.2 to 4.

7. The polishing composition of claim 1, further comprising an acid.

8. The polishing composition of claim 1, further comprising a chelating agent.

9. The polishing composition of claim 1, further comprising at least one of a surfactant and a hydrophilic polymer.

10. The polishing composition of claim 1, further comprising an alkali agent and buffer.

11. A method of chemical mechanical polishing comprising:
bringing the polishing composition of claim 1 into contact with a surface to be polished; and
polishing the surface by moving it relatively to a polishing surface.
